# EUROPEAN PATENT SPECIFICATION

(11) **EP 0 933 932 B1**
(45) Date of publication and mention of the grant of the patent: **21.05.2003**
(21) Application number: 99300389.6
(22) Date of filing: 20.01.1999
(51) Int. Cl.: H04N 5/44, H03H 7/01

(54) **Intermediate-frequency output circuit**
Zwischenfrequenz-Ausgangsschaltung
Circuit de sortie de fréquence intermédiaire

(30) Priority: 02.02.1998 JP 2091498
(43) Date of publication of application: 04.08.1999
(73) Proprietor: ALPS ELECTRIC CO., LTD., Ota-ku Tokyo 145 (JP)
(72) Inventor: Yamamoto, Masaki, Futabe-gun, Fukushima-ken (JP); Sasaki, Michinori, Babano, Soma-shi, Fukushima-ken (JP)
(74) Representative: Kensett, John Hinton

(56) References cited:
- US-A- 4 263 619
- US-A- 4 875 019
- US-A- 5 148 133
- PATENT ABSTRACTS OF JAPAN vol. 098, no. 005, 30 April 1998 & JP 10 022788 A (SHARP CORP), 23 January 1998

## Description

The present invention relates to an intermediate-frequency output circuit suitable for a television tuner, which is capable of attenuating video intermediate-frequency signals and voice intermediate-frequency signals on adjacent channels.

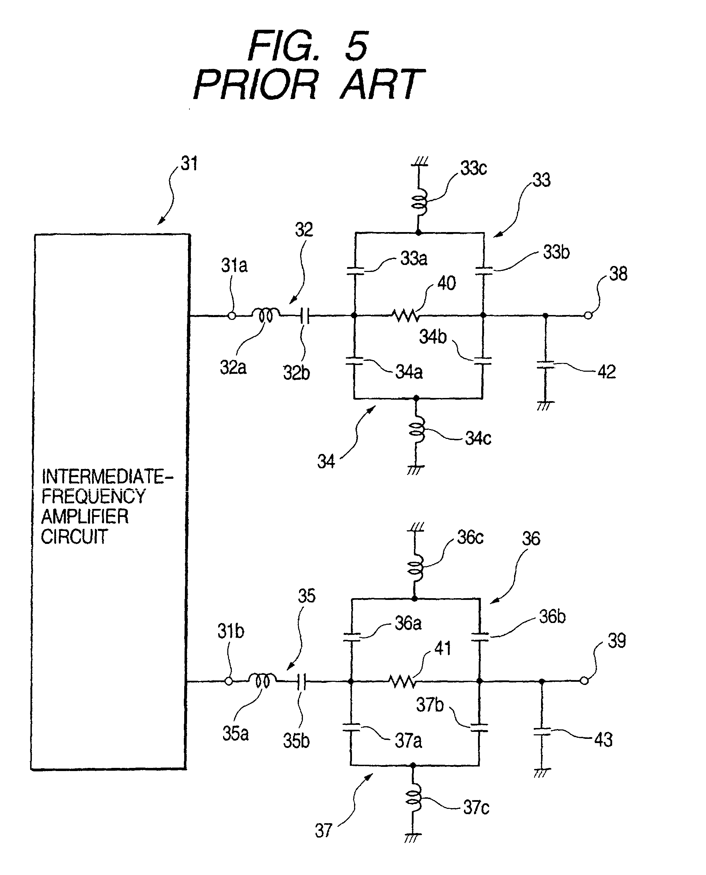

A conventional intermediate-frequency output circuit (hereinafter called an "IF output circuit") will be described with reference to Fig. 5. In Fig. 5, a television signal frequency-converted to an intermediate frequency signal by a mixer (not shown) of a television tuner is inputted to an intermediate-frequency amplifier circuit (hereinafter called an "IF amplifier circuit") 31.

Here, the IF amplifier circuit 31 is comprised of a differential amplifier circuit and the like as a balanced amplifier circuit.

One end of a first intermediate-frequency tuning circuit (hereinafter called a "first IF tuning circuit") 32 comprised of a series resonance circuit is electrically connected to one output terminal 31a of the IF amplifier circuit 31. Further, a bridge T-type first trap circuit 33 and a bridge T-type second trap circuit 34 are electrically connected in parallel with the other end of the first IF tuning circuit 32.

Similarly, one end of a second intermediate-frequency tuning circuit (hereinafter called a "second IF tuning circuit") 35 made up of a series resonance circuit is electrically connected even to the other output terminal 31b of the IF amplifier circuit 31. Further, a bridge T-type third trap circuit 36 and a bridge T-type fourth trap circuit 37 are electrically connected in parallel with the other end of the second IF tuning circuit 35.

Further, an output terminal 38 of the first trap circuit 33 and the second trap circuit 34, and an output terminal 39 of the third trap circuit 36 and the fourth trap circuit 37 are electrically connected to an intermediate-frequency amplifier circuit (not shown) on the television receiver side.

The first IF tuning circuit 32 comprises a coil 32a and a capacitor 32b. Similarly, the second IF tuning circuit 35 comprises a coil 35a and a capacitor 35b.

The resonant frequencies of the first IF tuning circuit 32 and the second IF tuning circuit 35 are respectively set to approximately the center frequency (approximately 36.15MHz in an European-spec (German) television tuner, for example).

Next, the first trap circuit 33 comprises a resistor 40 provided in series with a signal transmission line, two capacitors 33a an 33b whose one ends are respectively electrically connected to both ends of the resistor 40, and a coil 33c electrically connected between a point where the other ends of the two capacitors 33a and 33b are electrically connected, and the ground.

Similarly, the second trap circuit 34 comprises the resistor 40, two capacitors 34a and 34b whose one ends are respectively electrically connected to both ends of the resistor 40, and a coil 34c electrically connected between a point where the other ends of the two capacitors 34a and 34b are electrically connected, and the ground.

Next, the third trap circuit 36 comprises a resistor 41 provided in series with a signal transmission line, two capacitors 36a and 36b whose one ends are respectively electrically connected to both ends of the resistor 41, and a coil 36c electrically connected between a point where the other ends of the two capacitors 36a and 36b are electrically connected, and the ground.

Similarly, the fourth trap circuit 37 comprises the resistor 41, two capacitors 37a and 37b whose one ends are respectively electrically connected to both ends of the resistor 41, and a coil 37c electrically connected between a point where the other ends of the two capacitors 37a and 37b are electrically connected, and the ground.

Further, a capacitor 42 is provided between the output terminal 38 of the first trap circuit 33 and the second trap circuit 34, and the ground. Similarly, a capacitor 43 is provided between the output terminal 39 of the third trap circuit 36 and the fourth trap circuit 37, and the ground.

In the European-spec (e.g., German) television system on the other hand, the band per channel for the television signal varies according to VHF and UHF bands. The band corresponds to 7MHz in the VHF band, whereas it corresponds to 8MHz in the UHF band.

As a result, when a television signal on a specific channel lying in the VHF band is received, a voice intermediate-frequency signal (whose frequency: 40.4MHz) on one adjacent channel and a video intermediate-frequency signal (whose frequency: 31.9MHz) on the other adjacent channel are located in the vicinity of a video intermediate-frequency signal (whose frequency: 38.9MHz) and a voice intermediate-frequency signal (whose frequency: 33.4MHz) respectively.

On the other hand, when a television signal on a specific channel lying in the UHF band is received, a voice intermediate-frequency signal (whose frequency: 41.4MHz) on one adjacent channel and a video intermediate-frequency signal (whose frequency: 30.9MHz) on the other adjacent channel are placed respectively.

Therefore, even when either the television signal lying in the VHF band or the television signal lying in the UHF band is received, the video intermediate-frequency signals and voice intermediate-frequency signals on these adjacent channels might interfere with a television signal on a specific channel that one desires to receive.

Thus, a trap frequency of the first trap circuit 33 is set in advance so as to become the frequency (f₁ = 40.4MHz) of the voice intermediate-frequency signal on one adjacent channel lying in the VHF band. Further, a trap frequency of the second trap circuit 34 is set in advance so as to take the frequency (f₂ = 31.9MHz) of the video intermediate-frequency signal on the other adjacent channel lying in the VHF band.

Similarly, a trap frequency of the third trap circuit 36 is set in advance so as to take the frequency (f₃ = 41.4MHz) of the voice intermediate-frequency signal on one adjacent channel lying in the UHF band. Further, a trap frequency of the fourth trap circuit 37 is set in advance so as to take the frequency (f₄ = 30.9MHz) of the video intermediate-frequency signal on the other adjacent channel lying in the UHF band.

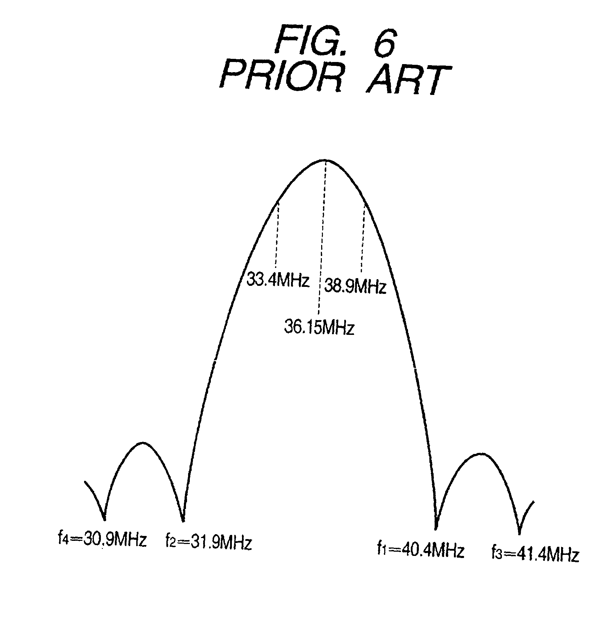

As a result, the voice intermediate-frequency signals and video intermediate-frequency signals on the adjacent channels were attenuated to thereby obtain a transmission characteristic shown in Fig. 6.

However, since bridge T-type trap circuits are provided only to attenuate a voice intermediate-frequency signal f₁ adjacent to a video intermediate-frequency signal on a specific channel lying in a VHF band, a video intermediate-frequency signal f₂ adjacent to a voice intermediate-frequency signal on a specific channel lying in the VHF band, a voice intermediate-frequency signal f₃ adjacent to a video intermediate-frequency signal on a specific channel in a UHF band, and a video intermediate-frequency signal f₄ adjacent to a voice signal on a specific channel in the UHF band, elements or devices to be used increase in number, thus causing an increase in cost.

Further, since each resistor is provided on a signal transmission line from the viewpoint of a configuration of each bridge T-type trap circuit, an intermediate frequency signal has been reduced in level.

US-A-4 263 619 discloses another trap circuit using T- type arrangements.

US-A-5 148 133 discloses L-type trap filter sections each having a parallel arrangement of an inductor and a capacitor and second inductor connected in series, inserted in the signal path.

With the foregoing problem in view, it is an object of the present invention to provide an IF output circuit at low cost, which is capable of obtaining attenuation similar to the prior art with a configuration simpler than that for a bridge T-type trap circuit and lessening a reduction in level.

According to one aspect of the invention, for achieving the above object, there is provided the intermediate-frequency output circuit claimed in claim 1, comprising a first intermediate-frequency tuning circuit comprised of a capacitor and a coil electrically connected in series; a first coil electrically connected in parallel with the first intermediate-frequency tuning circuit; a first capacitor electrically connected in parallel with the first intermediate-frequency tuning circuit; an intermediate-frequency amplifier circuit having a first output terminal to which one end of the first intermediate-frequency tuning circuit is electrically connected; a second intermediate-frequency tuning circuit comprised of a capacitor and a coil electrically connected in series, the second intermediate-frequency tuning circuit having one end electrically connected to a second output terminal of the intermediate-frequency amplifier circuit; a second coil electrically connected in parallel with the second intermediate-frequency tuning circuit; and a second capacitor electrically connected in parallel with the second intermediate-frequency tuning circuit, wherein intermediate frequency signals are taken out from the other ends of the first intermediate-frequency tuning circuit and the second intermediate-frequency tuning circuit, respectively, the first intermediate-frequency tuning circuit and the first coil constitute a first trap circuit, the first intermediate-frequency tuning circuit and the first capacitor constitute a second trap circuit, the second intermediate-frequency tuning circuit and the second coil constitute a third trap circuit, the second intermediate-frequency tuning circuit and the second capacitor constitute a fourth trap circuit, the first trap circuit and the third trap circuit trap a video intermediate-frequency signal on a first adjacent channel and a video intermediate-frequency signal on a second adjacent channel, and the second trap circuit and the fourth trap circuit trap a voice intermediate-frequency signal on a first adjacent channel and a voice intermediate-frequency signal on a second adjacent channel.

Preferably, the trap frequencies of the first and third trap circuits are set to the same frequency, and the trap frequencies of the second and fourth trap circuits are set to the same frequency.

According to another aspect of the invention, there is provided the intermediate-frequency output circuit claimed in claim 3, comprising a first intermediate-frequency tuning circuit comprised of a capacitor and a coil electrically connected in series; an inductor electrically connected in parallel with the first intermediate-frequency tuning circuit; an intermediate-frequency amplifier circuit having a first output terminal to which one end of the first intermediate-frequency tuning circuit is electrically connected; a second intermediate-frequency tuning circuit comprised of a capacitor and a coil electrically connected in series, the second intermediate-frequency tuning circuit having one end electrically connected to a second output terminal of the intermediate-frequency amplifier circuit; and capacitor means electrically connected in parallel with the second intermediate-frequency tuning circuit, wherein intermediate frequency signals are taken out from the other ends of the first intermediate-frequency tuning circuit and the second intermediate-frequency tuning circuit, respectively, the first intermediate-frequency tuning circuit and the inductor trap a video intermediate-frequency signals on an adjacent channel and the second intermediate-frequency tuning circuit and the capacitor means trap a voice intermediate-frequency signal on another adjacent channel.

While the specification concludes with claims particularly pointing out and distinctly claiming the subject matter which is regarded as the invention, it is believed that the invention, the objects and features of the invention and further objects, features and advantages thereof will be better understood from the following description taken in connection with the accompanying drawings in which:
Fig. 1 is a diagram showing an intermediate-frequency output circuit according to the present invention;
Fig. 2 is a transmission characteristic diagram of the intermediate-frequency output circuit shown in Fig. 1;
Fig. 3 is a transmission characteristic diagram of another embodiment according to the present invention;
Fig. 4 is a diagram illustrating a further embodiment of an intermediate-frequency output circuit according to the present invention;
Fig. 5 is a circuit diagram for describing a conventional intermediate-frequency output circuit; and
Fig. 6 is a transmission characteristic diagram of the conventional intermediate-frequency output circuit.

Preferred embodiments of the present invention will hereinafter be described, by example only.

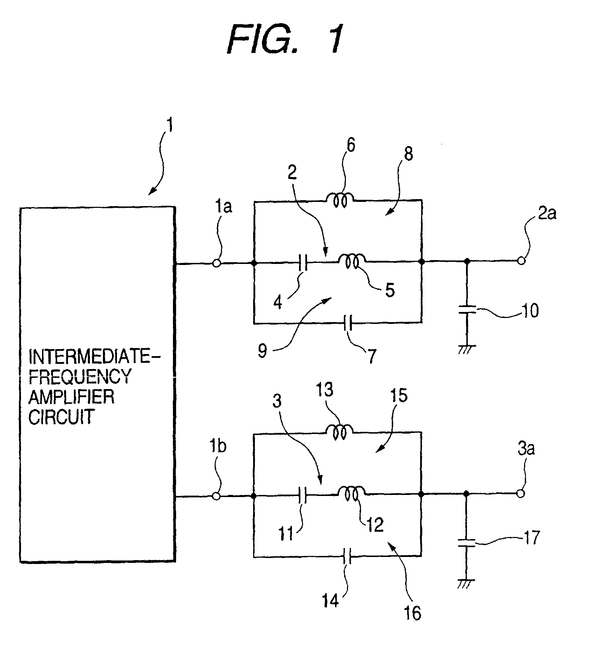

An intermediate-frequency output circuit (hereinafter called an "IF output circuit") according to the present invention will be explained in accordance with Fig. 1. In Fig. 1, a television signal frequency-converted to an intermediate frequency signal by a mixer (not shown) of a television tuner is inputted to an intermediate-frequency amplifier circuit (hereinafter called an "IF amplifier circuit") 1.

Here, the IF amplifier circuit 1 is comprised of a differential amplifier circuit and the like as a balanced amplifier circuit.

A first intermediate-frequency tuning circuit (hereinafter called a "first IF tuning circuit") 2 is electrically connected to a first output terminal 1a of the IF amplifier circuit 1. Similarly, a second intermediate-frequency tuning circuit (hereinafter called a "second IF tuning circuit") 3 is electrically connected to a second output terminal 1b of the IF amplifier circuit 1. Further, output terminals 2a and 3a of the IF tuning circuits 2 and 3 are electrically connected to an intermediate-frequency amplifier circuit (not shown) on the television receiver side.

First, the first IF tuning circuit 2 comprises a capacitor 4 and a coil 5 that are electrically connected in series. A first coil 6 which serves as inductor means and a first capacitor 7 which serves as capacitor means, are electrically connected in parallel with the first IF tuning circuit 2.

As a result, the first IF tuning circuit 2 and the first coil 6 constitute a first trap circuit 8. Further, the first IF tuning circuit 2 and the first capacitor 7 constitute a second trap circuit 9.

Further, a capacitor 10 is electrically connected between the output terminal 2a of the first IF tuning circuit 2 and the ground.

Similarly, the second IF tuning circuit 3 comprises a capacitor 11 and a coil 12 that are electrically connected in series. A second coil 13 which serves as inductor means and a second capacitor 14 which serves as capacitor means, are electrically connected in parallel with the second IF tuning circuit 3.

As a result, a third trap circuit 15 is made up of the second IF tuning circuit 3 and the second coil 13. Further, a fourth trap circuit 16 is comprised of the second IF tuning circuit 3 and the second capacitor 14.

Further, a capacitor 17 is electrically connected between the output terminal 3a of the second IF tuning circuit 3 and the ground.

Now, the tuning frequency of the first IF tuning circuit 2 and the tuning frequency of the second IF tuning circuit 3 are set to a center frequency lying in an intermediate frequency band, e.g., nearly 36.15MHz in an European (German) television system.

Thus, the first trap circuit 8 and the third trap circuit 15 trap frequencies lower than the center frequency in the intermediate frequency band, whereas the second trap circuit 9 and the fourth trap circuit 16 trap frequencies higher than the center frequency in the intermediate frequency band.

In the European (German) television system, for example, the band per channel for a television signal lying in a VHF band is defined as 7MHz, and the band per channel for a television signal lying in a UHF band is defined as 8MHz.

As a result, when a television signal on a specific channel lying in the VHF band is received, a voice intermediate-frequency signal (whose frequency: 40.4MHz) on one adjacent channel and a video intermediate-frequency signal (whose frequency: 31.9MHz) on the other adjacent channel are located in the vicinity of a video intermediate-frequency signal (whose frequency: 38.9MHz) and a voice intermediate-frequency signal (whose frequency: 33.4MHz) respectively.

On the other hand, when a television signal on a specific channel lying in the UHF band is received, a voice intermediate-frequency signal (whose frequency: 41.4MHz) on one adjacent channel and a video intermediate-frequency signal (whose frequency: 30.9MHz) on the other adjacent channel are located in the vicinity of the video intermediate-frequency signal and the voice intermediate-frequency signal respectively.

Therefore, the trap frequency of the first trap circuit 8 is set in advance to the frequency (f₁ = 31.9MHz) of the video intermediate-frequency signal (called "video intermediate-frequency signal on a first adjacent channel") on one adjacent channel lying in the VHF band. Further, the trap frequency of the second trap circuit 9 is set in advance to the frequency (f₂ = 40.4MHz) of the voice intermediate-frequency signal (called "voice intermediate-frequency signal on a second adjacent channel") on the other adjacent channel lying in the VHF band.

Similarly, the trap frequency of the third trap circuit 15 is set in advance to the frequency (f₃ = 30.9MHz) of the video intermediate-frequency signal (called "video intermediate-frequency signal on a second adjacent channel") on one adjacent channel lying in the UHF band. Further, the trap frequency of the fourth trap circuit 16 is set in advance to the frequency (f₄ = 41.4MHz) of the voice intermediate-frequency signal (called "voice intermediate-frequency signal on a second adjacent channel") on the other adjacent channel lying in the UHF band.

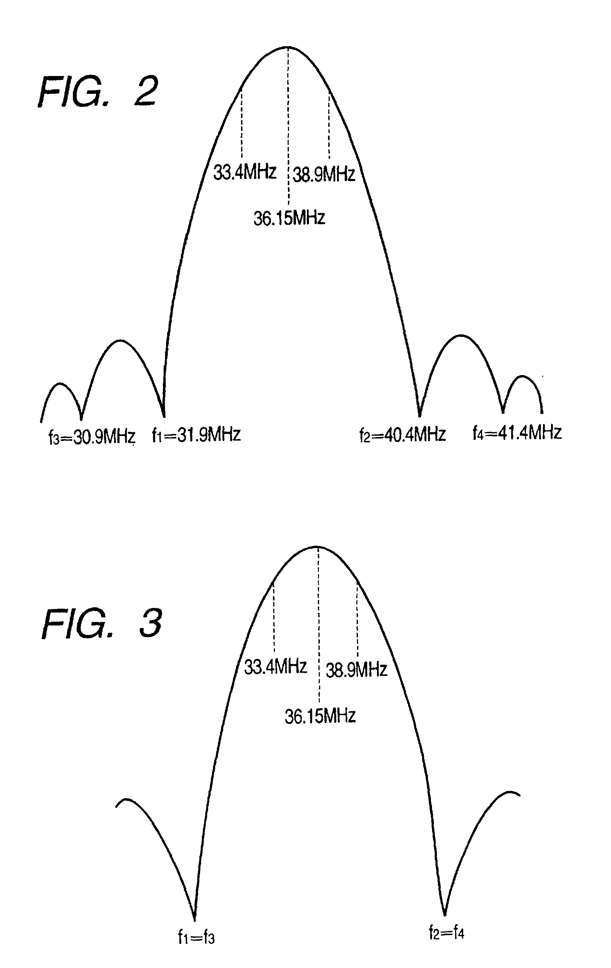

Thus, the IF output circuit can obtain such a transmission characteristic as shown in Fig. 2. Even when either the television signal lying in the VHF band or the television signal lying in the UHF band is received with a simple circuit configuration, the IF output circuit can reduce interference produced due to the video intermediate-frequency signal and voice intermediate-frequency signal on the adjacent channels.

When it is desired to greatly attenuate only a video intermediate-frequency signal and a voice intermediate-frequency signal on adjacent channels lying in a VHF band in particular, when only a television signal lying in the VHF band is used as in an European television system except for Germany, and when the bands per channel for the television signals lying in the VHF and UHF bands are identical to each other, the trap frequency of the first trap circuit 8 and the trap frequency of the third trap circuit 15 are designed so as to be equal to each other in advance, and the trap frequencies of the second trap circuit 9 and the fourth trap circuit 16 are designed so as to become equal to each other in advance. As a result, the video intermediate-frequency signal and voice intermediate-frequency signal on the adjacent channels can be attenuated stronger.

As a result, the present IF output circuit can obtain such a transmission characteristic as illustrated in Fig. 3.

In this case, the trap frequencies of the first through fourth trap circuits 8, 9, 15 and 16 may suitably be set in association with the video intermediate-frequency signal and voice intermediate-frequency signal on the adjacent channels.

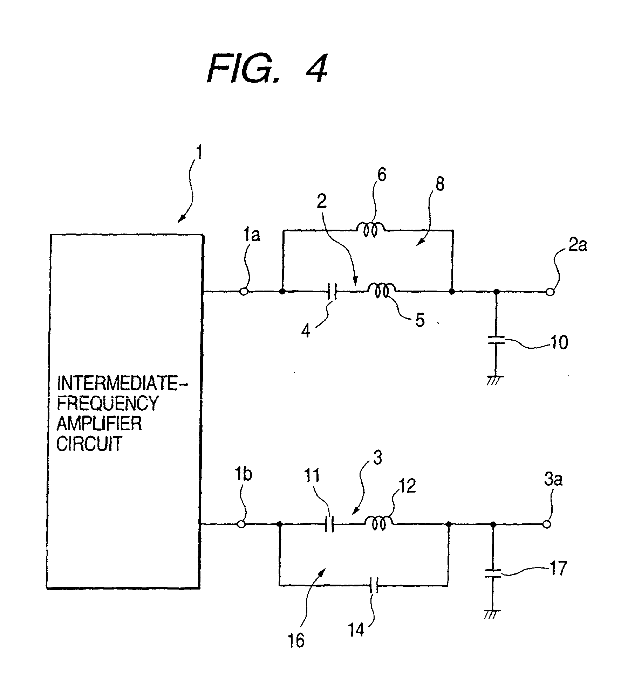

Further, Fig. 4 shows an output circuit except for the first capacitor 7 and second coil 13 employed in the intermediate-frequency output circuit shown in Fig. 1. Fig. 4 illustrates, for example, an IF output circuit suitable for a television system for a case in which television signals lying within VHF and UHF bands are identical to each other in per-channel band (the band per channel corresponds to 6MHz in Japan, for example).

Further, the trap frequency of a first trap circuit 8 and the trap frequency of a fourth trap circuit 16 may be set in advance to the frequency of a video intermediate-frequency signal on one adjacent channel and the frequency of a voice intermediate-frequency signal on the other adjacent channel, respectively.

Thus, the present IF output circuit brings about such a transmission characteristic as illustrated in Fig. 3. Therefore, the IF output circuit can attenuate the video intermediate-frequency signal and the voice intermediate-frequency signal on the adjacent channels with a simpler circuit configuration.

According to an intermediate-frequency output circuit of the present invention as has been described above, a first coil and a first capacitor are provided in parallel with a first intermediate-frequency tuning circuit. A second coil and a second capacitor are provided in parallel with a second intermediate-frequency tuning circuit. The first intermediate-frequency tuning circuit and the first coil constitute a first trap circuit. Similarly, the first intermediate-frequency tuning circuit and the first capacitor constitute a second trap circuit, and the second intermediate-frequency tuning circuit and the second coil constitute a third trap circuit. Similarly, the second intermediate-frequency tuning circuit and the second capacitor constitute a fourth trap circuit. The first trap circuit and the third trap circuit trap a video intermediate-frequency signal on a first adjacent channel and a video intermediate-frequency signal on a second adjacent channel, whereas the second trap circuit and the fourth trap circuit trap a voice intermediate-frequency signal on a first adjacent channel and a voice intermediate-frequency signal on a second adjacent channel. As a result, an intermediate-frequency output circuit which is reduced in parts count and simple, can be realized and can obtain attenuation similar to ever at low cost. Further, since no bridge T-type trap circuit is used, the level of the intermediate frequency signal is not reduced.

According to the intermediate-frequency output circuit of the present invention as well, the trap frequency of the first trap circuit and the trap frequency of the third trap circuit are respectively set to the same frequency. The trap frequency of the second trap circuit and the trap frequency of the fourth trap circuit are set to the same frequency. The first trap circuit and the third trap circuit trap video intermediate-frequency signals on an adjacent channel, whereas the second trap circuit and the fourth trap circuit trap voice intermediate-frequency signals on another adjacent channel. As a result, the adjacent video intermediate-frequency signal and voice intermediate-frequency signal, which cause interference, can be attenuated stronger.

Further, according to the intermediate-frequency output circuit of the present invention, a first intermediate-frequency tuning circuit is provided in which a capacitor and a coil are electrically connected in series. An inductor is electrically connected in parallel with the first intermediate-frequency tuning circuit. One end of the first intermediate-frequency tuning circuit is electrically connected to a first output terminal of an intermediate-frequency amplifier circuit. A second intermediate-frequency tuning circuit is provided in which a capacitor and a coil are electrically connected in series. Capacitor means is electrically connected in parallel with the second intermediate-frequency amplifier circuit. One end of the second intermediate-frequency tuning circuit is electrically connected to a second output terminal of the intermediate-frequency amplifier circuit. Intermediate frequency signals are taken out from the other ends of the first intermediate-frequency tuning circuit and the second intermediate-frequency tuning circuit. The first intermediate-frequency tuning circuit and the inductor trap a video intermediate-frequency signal on an adjacent channel, and the second intermediate-frequency tuning circuit and the capacitor means trap a voice intermediate-frequency signal on another adjacent channel. Thus, when television signals lying within VHF and UHF bands are identical to each other in per-channel band, attenuation characteristics similar to ever can be obtained by a simpler circuit.

While the present invention has been described with reference to the illustrative embodiments, this description is not intended to be construed in a limiting sense. Various modifications of the illustrative embodiments, as well as other embodiments of the invention, will be apparent to those skilled in the art on reference to this description. It is therefore contemplated that the appended claims will cover any such modifications or embodiments as fall within the true scope of the invention.

## Claims

1. An intermediate-frequency output circuit, comprising:
a first intermediate-frequency tuning circuit (2) comprised of a capacitor (4) and a coil (5) electrically connected in series and tuned to the center frequency of a television signal channel;
a first coil (6) electrically connected in parallel with said first intermediate-frequency tuning circuit;
a first capacitor (7) electrically connected in parallel with said first intermediate-frequency tuning circuit;
an intermediate-frequency amplifier circuit (1) having a first output terminal (1a) to which one end of said first intermediate-frequency tuning circuit is electrically connected;
a second intermediate-frequency tuning circuit (3) comprised of a capacitor (11) and a coil (12) electrically connected in series and tuned to the center frequency of said television signal channel, said second intermediate-frequency tuning circuit having one end electrically connected to a second output terminal (15) of said intermediate-frequency amplifier circuit;
a second coil (13) electrically connected in parallel with said second intermediate-frequency tuning circuit; and
a second capacitor (14) electrically connected in parallel with said second intermediate-frequency tuning circuit,
wherein
intermediate frequency signals are taken out from the other ends (2a,3a) of said first intermediate-frequency tuning circuit and said second intermediate-frequency tuning circuit, respectively;
said first intermediate-frequency tuning circuit (2) and said first coil (6) constitute a first trap circuit (8);
said first intermediate-frequency tuning circuit (2) and said first capacitor (7) constitute a second trap circuit (9);
said second intermediate-frequency tuning circuit (3) and said second coil (13), constitute a third trap circuit (15); and
said second intermediate-frequency tuning circuit (3) and said second capacitor (14) constitute a fourth trap circuit (16),
said first trap circuit (8) and said third trap circuit (15) are respectively tuned to trap a video intermediate-frequency signa(f₁) on a first adjacent channel and a video intermediate-frequency signal (f₃) on a second adjacent channel, lower than said center frequency, and
said second trap circuit (9) and said fourth trap circuit (16) are respectively tuned to trap a voice intermediate-frequency signals (f₂) on a first adjacent channel and a voice intermediate-frequency signal (f₄) on a second adjacent channel, higher than said center frequency.

2. The intermediate-frequency output circuit according to claim 1, wherein the trap frequencies of said first and third trap circuits are set to the same frequency, the trap frequencies of said second and fourth trap circuits are set to the same frequency.

3. An intermediate-frequency output circuit, comprising:
a first intermediate-frequency tuning circuit (2) comprised of a capacitor (4) and a coil (5) electrically connected in series and tuned to the center frequency of a television signal channel;
an inductor (6) electrically connected in parallel with said first intermediate-frequency tuning circuit;
an intermediate-frequency amplifier circuit (1) having a first output terminal (1a) to which one end of said first intermediate-frequency tuning circuit is electrically connected;
a second intermediate-frequency tuning circuit (3) comprised of a capacitor (11) and a coil (12) electrically connected in series and tuned to the center frequency of said television signal channel, said second intermediate-frequency tuning circuit having one end electrically connected to a second output terminal (1b) of said intermediate-frequency amplifier circuit; and
capacitor means (14) electrically connected in parallel with said second intermediate-frequency tuning circuit;
wherein intermediate frequency signals are taken out from the other ends (2a,3a) of said first intermediate-frequency tuning circuit and said second intermediate-frequency tuning circuit, respectively,
said first intermediate-frequency tuning circuit and said inductor are tuned to trap a video intermediate-frequency signal (f₁;f₃) on an adjacent channel and
said second intermediate-frequency tuning circuit and said capacitor means, are tunned to trap a voice intermediate-frequency signal on another adjacent channel.

## Patentansprüche

1. Zwischenfrequenz-Ausgabeschaltung, die umfasst:
eine erste Zwischenfrequenz-Abstimmschaltung (2), die einen Kondensator (4) und eine Spule (5), die elektrisch in Reihe geschaltet sind, enthält und auf die Mittenfrequenz eines Fernsehsignal-Kanals abgestimmt ist;
eine erste Spule (6), die zu der ersten Zwischenfrequenz-Abstimmschaltung elektrisch parallel geschaltet ist;
einen ersten Kondensator (7), der zu der ersten Zwischenfrequenz-Abstimmschaltung elektrisch parallel geschaltet ist;
eine Zwischenfrequenz-Verstärkerschaltung (1), die einen ersten Ausgangsanschluss (1a) besitzt, an den ein Ende der ersten Zwischenfrequenz-Abstimmschaltung elektrisch angeschlossen ist;
eine zweite Zwischenfrequenz-Abstimmschaltung (3), die einen Kondensator (11) und
eine Spule (12), die elektrisch in Reihe geschaltet sind, enthält und auf die Mittenfrequenz des Fernsehsignal-Kanals abgestimmt ist, wobei die zweite Zwischenfrequenz-Abstimmschaltung mit einem Ende an einen zweiten Ausgangsanschluss (1b) der Zwischenfrequenz-Verstärkerschaltung angeschlossen ist:
eine zweite Spule (13), die zu der zweiten Zwischenfrequenz-Abstimmschaltung elektrisch parallel geschaltet ist; und
einen zweiten Kondensator (14), der zu der zweiten Zwischenfrequenz-Abstimmschaltung elektrisch parallel geschaltet ist, wobei
an den jeweils anderen Enden (2a, 3a) der ersten Zwischenfrequenz-Abstimmschaltung bzw. der zweiten Zwischenfrequenz-Abstimmschaltung Zwischenfrequenzsignale abgegriffen werden;
die erste Zwischenfrequenz-Abstimmschaltung (2) und die erste Spule (6) eine erste Sperrschaltung (8) bilden;
die erste Zwischenfrequenz-Abstimmschaltung (2) und der erste Kondensator (7) eine zweite Sperrschaltung (9) bilden;
die zweite Zwischenfrequenz-Abstimmschaltung (3) und die zweite Spule (13) eine dritte Sperrschaltung (15) bilden; und
die zweite Zwischenfrequenz-Abstimmschaltung (3) und der zweite Kondensator (14) eine vierte Sperrschaltung (16) bilden,
wobei die erste Sperrschaltung (8) und die dritte Sperrschaltung (15) jeweils so abgestimmt sind, dass sie ein Videozwischenfrequenzsignal (f₁) auf einem ersten benachbarten Kanal bzw. ein Videozwischenfrequenzsignal (f₃) auf einem zweiten benachbarten Kanal, die niedriger als die Zwischenfrequenz sind, sperren, und die zweite Sperrschaltung (9) und die vierte Sperrschaltung (16) jeweils so abgestimmt sind, dass sie ein Sprachzwischenfrequenzsignal (f₂) auf einem ersten benachbarten Kanal und ein Sprachzwischenfrequenzsignal (f₄) auf einem zweiten benachbarten Kanal, die höher als die Mittenfrequenz sind, sperren.

2. Zwischenfrequenz-Ausgabeschaltung nach Anspruch 1, bei der die Sperrfrequenzen der ersten und der dritten Sperrschaltungen auf die gleiche Frequenz gesetzt sind und die Sperrfrequenzen der zweiten und der vierten Sperrschaltungen auf die gleiche Frequenz gesetzt sind.

3. Zwischenfrequenz-Ausgabeschaltung, die umfasst:
eine erste Zwischenfrequenz-Abstimmschaltung (2), die einen Kondensator (4) und eine Spule (5), die elektrisch in Reihe geschaltet sind, enthält und auf die Mittenfrequenz eines Fernsehsignal-Kanals abgestimmt ist;
eine Induktivität (6), die zu der ersten Zwischenfrequenz-Abstimmschaltung elektrisch parallel geschaltet ist;
eine Zwischenfrequenz-Verstärkerschaltung (1), die einen ersten Ausgangsanschluss (1a) besitzt, an den ein Ende der ersten Zwischenfrequenz-Abstimmschaltung elektrisch angeschlossen ist;
eine zweite Zwischenfrequenz-Abstimmschaltung (3), die einen Kondensator (11) und eine Spule (12), die elektrisch in Reihe geschaltet sind, enthält und auf die Mittenfrequenz des Fernsehsignal-Kanals abgestimmt ist, wobei die zweite Zwischenfrequenz-Abstimmschaltung mit einem Ende an einen zweiten Ausgangsanschluss (1b) der Zwischenfrequenz-Verstärkerschaltung elektrisch angeschlossen ist; und
Kondensatormittel (14), die zu der zweiten Zwischenfrequenz-Abstimmschaltung elektrisch parallel geschaltet sind;
wobei Zwischenfrequenzsignale von den jeweils anderen Enden (2a, 3a) der ersten Zwischenfrequenz-Abstimmschaltung bzw. der zweiten Zwischenfrequenz-Abstimmschaltung abgegriffen werden,
die erste Zwischenfrequenz-Abstimmschaltung und die Induktivität so abgestimmt sind, dass sie ein Videozwischenfrequenzsignal (f₁, f₃) auf einem benachbarten Kanal sperren, und
die zweite Zwischenfrequenz-Abstimmschaltung und die Kondensatormittel so abgestimmt sind, dass sie ein Sprachzwischenfrequenzsignal auf einem weiteren benachbarten Kanal sperren.

## Revendications

1. Un circuit de sortie de fréquence intermédiaire comprenant:
un premier circuit d'accord (2) de fréquence intermédiaire comprenant un condensateur (4) et une bobine (5) connectés électriquement en série et accordés à la fréquence centrale d'un canal de signal de télévision;
une première bobine (6) connectée électriquement en parallèle avec ce premier circuit d'accord de fréquence intermédiaire ;
un premier condensateur (7) connecté électriquement en parallèle avec le premier circuit d'accord de fréquence intermédiaire;
un circuit amplificateur (1) de fréquence intermédiaire ayant une première borne de sortie (1a) à laquelle une extrémité du premier circuit d'accord de fréquence intermédiaire est connecté électriquement;
un deuxième circuit d'accord (3) de fréquence intermédiaire comprenant un condensateur (11) et une bobine (12) connectés électriquement en série et accordés sur la fréquence centrale de ce canal de signal de télévision, ce deuxième circuit d'accord de fréquence intermédiaire ayant une de ses extrémités connectées à une deuxième borne de sortie (1b) du circuit amplificateur de fréquence intermédiaire ;
une deuxième bobine (13) connectée électriquement en parallèle au deuxième circuit d'accord de fréquence intermédiaire; et
un deuxième condensateur (14) connecté électriquement en parallèle au deuxième circuit d'accord de fréquence intermédiaire, dans lequel
des signaux de fréquence intermédiaire sont tirés des autres extrémités (2a, 3a) du premier circuit d'accord de fréquence intermédiaire et du deuxième circuit d'accord de fréquence intermédiaire, respectivement ;
ce premier circuit d'accord (2) de fréquence intermédiaire et cette première bobine (6) constituent un premier circuit d'interception (8);
ce premier circuit d'accord (2) de fréquence intermédiaire et ce premier condensateur (7) constituent un deuxième circuit d'interception (9) ;
le deuxième circuit d'accord (3) de fréquence intermédiaire et la deuxième bobine (13) constituent un troisième circuit d'interception (15) ; et
le deuxième circuit (3) de fréquence intermédiaire et le deuxième condensateur (14) constituent un quatrième circuit d'interception (16),
le premier circuit d'interception (8) et le troisième circuit d'interception (15) sont accordés respectivement pour intercepter un signal (f₁) de vidéo de fréquence intermédiaire sur un premier canal adjacent et un signal (f₃) de vidéo de fréquence intermédiaire sur un deuxième canal adjacent, en-dessous de la fréquence centrale, et
le deuxième circuit d'interception (9) et le quatrième circuit d'interception (16) sont accordés respectivement pour intercepter un signal (f₂) vocal de fréquence intermédiaire sur un premier canal adjacent et un signal vocal (f₄) de fréquence intermédiaire sur un deuxième canal adjacent, au-dessus de la fréquence centrale.

2. Le circuit de sortie de fréquence intermédiaire selon la revendication 1, dans lequel les fréquences d'interception du premier et du troisième circuit d'interception sont réglées à la même fréquence ; et les fréquences d'interception du deuxième et du quatrième circuit d'interception sont réglées à la même fréquence.

3. Un circuit de sortie de fréquence intermédiaire, comprenant :
un premier circuit d'accord (2) de fréquence intermédiaire comprenant un condensateur (4) et une bobine (5) connectés électriquement en série et accordés à la fréquence centrale d'un canal de signal de télévision ;
une bobine d'inductance(6) connectée électriquement en parallèle avec le premier circuit d'accord de fréquence intermédiaire ;
un circuit d'amplification (1) de fréquence intermédiaire ayant une première borne de sortie (1a) à laquelle une extrémité de ce premier circuit d'accord de fréquence intermédiaire est connectée électriquement ;
un deuxième circuit d'accord (3) de fréquence intermédiaire comprenant un condensateur (11) et une bobine (12) connectés électriquement en série et accordés à la fréquence centrale du canal de signal de télévision, ce circuit d'accord de fréquence intermédiaire ayant une extrémité connectée électriquement à une deuxième borne (13) de sortie du circuit amplificateur de fréquence intermédiaire; et
un condensateur (14) connecté électriquement en parallèle avec le deuxième circuit d'accord de fréquence intermédiaire ;
dans lequel les signaux de fréquence intermédiaire sont extraits des autres extrémités (2a, 3a) du premier circuit d'accord de fréquence intermédiaire et du deuxième circuit de fréquence intermédiaire, respectivement.
ce premier circuit d'accord de fréquence intermédiaire et la bobine d'inductance sont accordés pour intercepter un signal de vidéo (f₁ ; f₃) de fréquence intermédiaire sur un canal adjacent, et
le deuxième circuit d'accord de fréquence intermédiaire et le condensateur sont accordés pour intercepter un signal vocal de fréquence intermédiaire sur un autre canal adjacent.
